**Europäisches Patentamt**

**European Patent Office**

**Office européen des brevets**

(19)

(11) **EP 1 530 250 A1**

(12) **EUROPÄISCHE PATENTANMELDUNG**

(43) Veröffentlichungstag:
   **11.05.2005 Patentblatt 2005/19**

(51) Int Cl.⁷: **H01P 1/213**, H03H 7/46

(21) Anmeldenummer: **04104849.7**

(22) Anmeldetag: **04.10.2004**

(84) Benannte Vertragsstaaten:
   **AT BE BG CH CY CZ DE DK EE ES FI FR GB GR
   HU IE IT LI LU MC NL PL PT RO SE SI SK TR**
   Benannte Erstreckungsstaaten:
   **AL HR LT LV MK**

(30) Priorität: **06.11.2003 DE 10351898**

(71) Anmelder: **ROBERT BOSCH GMBH
   70442 Stuttgart (DE)**

(72) Erfinder:
   • **Kottschlag, Gerhard
      31139 Hildesheim (DE)**
   • **Pochowski, Lutz
      31141 Hildesheim (DE)**
   • **Pitz, Gerhard
      31139 Hildesheim (DE)**

(54) **Empfängeranordnung mit mindestens zwei an eine gemeinsame Antenne angeschlossenen Empfängern und Verfahren zur Steuerung derselben**

(57)    Vorgeschlagen werden eine Empfängeranordnung mit mindestens zwei an eine gemeinsame Antenne (40) angeschlossenen Empfängern (20,30), die über Antennensignalleitungen (25,35) mit der Antenne (40) verbunden sind,
wobei jeder der Empfänger (20,30) ein steuerbares Vorfilter (21,31) mit bandpassförmiger Charakteristik und eine steuerbare Empfangsfrequenz (81,82) aufweist,
mit einer Steuerung (50) zur Steuerung der Vorfilter (23,33) und der Empfangsfrequenzen (81,82) der Empfänger,
wobei die Steuerung (50) dazu ausgebildet ist, die Empfangsfrequenzen der Empfänger (20,30) voneinander unabhängig auf voneinander verschiedene Funkfrequenzen (81,82) einzustellen
dadurch gekennzeichnet,
dass die Steuerung (50) ferner dazu ausgebildet ist, die Vorfilter (21,31) derart einzustellen, dass jede der eingestellten Empfangsfrequenzen (81,82) im Durchlassbereich des jeweiligen Vorfilters (21,31) liegt, wobei die Mittenfrequenzen (61,62) der Durchlassbereiche der Vorfilter (21,31) nicht mit den Empfangsfrequenzen (81,82) übereinstimmen müssen.

Die Erfindung ermöglicht in vorteilhafter Weise eine flexiblere Steuerung einer an sich bekannten Empfängeranordnung, mit dem positiven Effekt, dass die Empfänger der Empfängeranordnung auf benachbarte Frequenzen abgestimmt werden können, die einen geringeren Abstand zueinander aufweisen können. Dies ermöglicht eine bessere Ausnutzung der im Frequenzband liegenden und an einem Empfängerstandort empfangbaren Frequenzen.

Fig. 2

EP 1 530 250 A1

**Beschreibung**

Stand der Technik

Die Erfindung geht von einer Empfängeranordnung mit mindestens zwei an eine gemeinsame Antenne angeschlossenen Empfängern und einem Verfahren zur Steuerung von an eine gemeinsame Antenne angeschlossenen Empfängern nach der Gattung der unabhängigen Patentansprüche aus.

Sollen in einem Funkempfänger, insbesondere einem Rundfunkempfänger, mehrere Signale gleichzeitig ausgewertet werden, z. B. Rundfunksignale eines eine Musiksendung ausstrahlenden Rundfunksenders und weitere Rundfunksignale eines weiteren, beispielsweise digital codierte Verkehrsfunkinformationen ausstrahlenden Senders, so wird das von einer Empfangsantenne empfangene Rundfunkfrequenzgemisch, in dem auch die Rundfunkfrequenzen der interessierenden Sender enthalten sind, von einem Antennensignalsplitter auf die verschiedenen, auf die Rundfunkfrequenzen der interessierenden Sender abgestimmten Empfänger aufgeteilt.

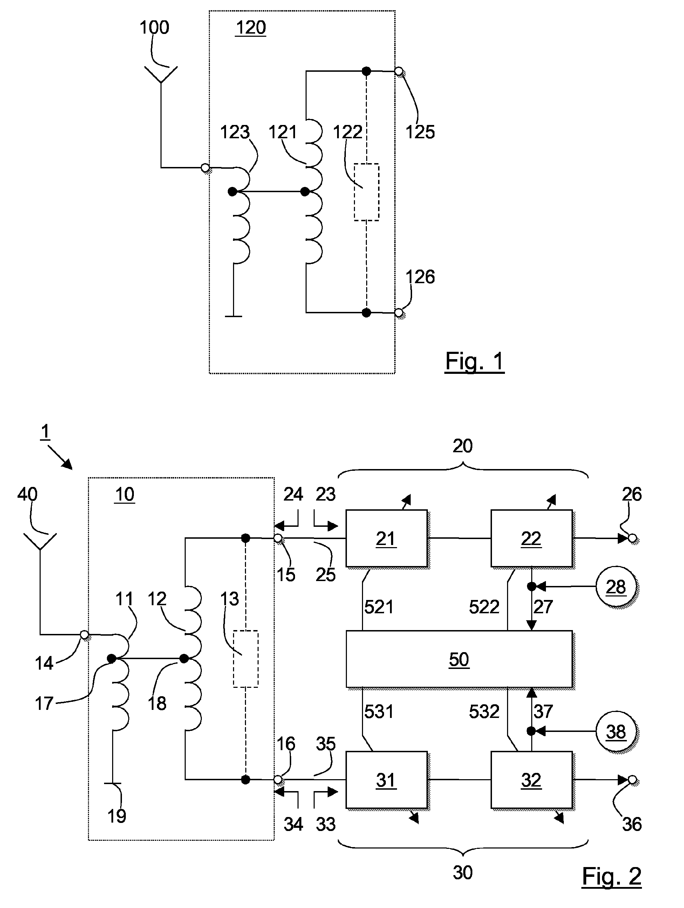

Oftmals wird hierzu ein Antennensignalsplitter 120 gemäss Figur 1 verwendet, der aus einem Transformator 121 mit mehreren Windungen und Mittelanzapfung zur Zuführung des Antennensignals der Empfangsantenne 100 sowie Anschlüssen 125, 126 zur Auskopplung des gesplitteten Antennensignals durch die angeschlossenen Empfänger und darüber hinaus die Ausgangsanschlüsse 125, 126 überbrückenden Widerständen 122 besteht. Durch geeignete Wahl des Widerstandswerts des bzw. der Widerstände 122, nämlich beispielsweise bei einem Splitter mit zwei Ausgängen idealer Weise dem doppelten der Eingangsimpedanz der an die Ausgangsanschlüsse 125, 126 des Splitters 120 angeschlossenen Empfängerzüge, die idealer Weise der Impedanz der Antennensignalleitung entspricht, wird eine bidirektionale Anpassung der Antennensignalsplitterausgänge 125 und 126 an die Impedanz des Systems oder des jeweiligen Empfängers erreicht. Ein zusätzlicher Eingangstransformator 123 passt die Impedanz der Antenne 100 bzw. der Antennenzuleitung an die Eingangsimpedanz des splittenden Transformators 121 an.

Diese Schaltung ist breitbandig verwendbar und unempfmdlich gegenüber Fehlanpassung an einzelnen Antennensignalsplitterausgängen 125, 126. Nachteilig ist die im gesamten nutzbaren Frequenzbereich wirkende Dämpfung, die aufgrund der breitbandigen Signalaufteilung zwangsläufig entsteht.

DE 101 31 457 A1 schlägt daher eine Anordnung zum Anschluss mindestens zweier Empfänger an eine gemeinsame Antenne vor, bei der die Eingangsimpedanzen der mindestens zwei Empfänger nur schmalbandig im Bereich ihrer aktuellen Empfangsfrequenzen an die Impedanzen der ihnen zugeführten Antennensignalleitungen angepasst sind. Durch die Impedanzanpassung wird eine Signalweiterleitung vom Antennensignalsplitter zu den Empfängern optimiert. Für alle anderen Frequenzen, die mit den Empfangsfrequenzen der Empfänger bzw. diesen eng benachbarten Frequenzen nicht übereinstimmen, weicht die jeweilige Eingangsimpedanz der Empfänger stark von der Splitter-Ausgangsimpedanz ab, was eine Signalreflexion an den Eingängen der Empfänger zur Folge hat.

DE 101 31 457 A1 schlägt weiter ein Verfahren zur Steuerung der Empfangsfrequenzen der beiden Empfänger vor, bei dem die Empfangsfrequenzen der mindestens zwei Empfänger so eingestellt werden, dass sie zueinander einen vorgegebenen Mindestfrequenzabstand einhalten. Vorzugsweise ist dabei vorgesehen, dass bei Verschlechterung der Empfangsqualität einer mittels eines ersten der mindestens zwei Empfänger empfangenen Empfangsfrequenz unter einen vorgegebenen Wert und für den Fall, dass die Empfangsfrequenz des mindestens einen weiteren Empfängers einen vorgegebenen Mindestfrequenzabstand zu der Empfangsfrequenz des ersten Empfängers nicht aufweist, die Empfangsfrequenz des mindestens einen weiteren Empfängers so eingestellt wird, dass sie zur Empfangsfrequenz des ersten Empfängers einen vorgegebenen Mindestfrequenzabstand einhält. Der Mindestfrequenzabstand ist dabei durch die Bandbreite vorgegeben, innerhalb derer die Empfänger eine Eingangsimpedanzanpassung an die ihnen zugeführten Antennensignalleitungen aufweisen.

Dem liegt die auch schon aus GB 613 927 bekannte Erkenntnis zugrunde, dass an einem jeweiligen Empfänger nur dann eine maximale Empfangssignalleistung für die betrachtete Frequenz vorliegt, wenn die beiden Empfängerzüge auf voneinander verschiedene Empfangsfrequenzen abgestimmt sind, so dass das Antennensignal für eine jeweils betrachtete Empfangsfrequenz nur von einem der Empfänger aus dem System ausgekoppelt, von den übrigen Empfängern hingegen reflektiert wird. Dies ist nur dann zu verwirklichen, wenn betreffend einer bestimmten interessierenden Empfangsfrequenz nur ein einziger Empfänger eine Eingangsimpedanzanpassung, die übrigen Empfänger hingegen einer Eingangsimpedanzfehlanpassung aufweisen. GB 613 927 sieht dazu vor, dass jedem an die Antenne angeschlossenen Empfänger ein bandpassförmiges festes Vorfilter vorgeschaltet ist, so dass durch die jeweiligen Empfänger jeweils nur ein Ausschnitt des gesamten Frequenzspektrums bzw. Frequenzbandes auswertbar ist.

DE 101 31 457 A1 geht ferner davon aus, dass die Empfangsfrequenzen der mindestens zwei Empfänger zur Erzielung einer möglichst geringen Dämpfung des Antennensignals im Bereich der Mittenfrequenzen der Durchlassbereiche der Vorfilter liegen müssen bzw. die Mittenfrequenzen der Vorfilter den eingestellten Empfangsfrequenzen exakt nachgeführt werden.

Vorteile der Erfindung

Die erfindungsgemäße Anordnung sowie das erfindungsgemäße Verfahren mit den Merkmalen der unabhängigen Patentansprüche ermöglichen in vorteilhafter Weise eine flexiblere Steuerung der aus DE 101 31 457 A1 an sich bekannten Empfängeranordnung mit dem positiven Effekt, dass die Empfänger der Empfängeranordnung auf benachbarte Frequenzen abgestimmt werden können, die einen geringeren Abstand zueinander aufweisen können, als dies in DE 101 31 457 A1 gefordert ist. Dies ermöglicht eine bessere Ausnutzung der im Frequenzband liegenden und an einem Empfängerstandort empfangbaren Frequenzen. Dies ist besonders im Falle eines Rundfunkempfängers, insbesondere eines Rundfunkempfängers für mobile Anwendungen, etwa eines Autoradios, von besonderem Vorteil, bei dem die Zahl der empfangbaren Rundfunkfrequenzen maßgeblich von geographischen Gegebenheiten an einem jeweiligen Empfängerstandort beeinflusst und oftmals erheblich eingeschränkt wird.

Dazu ist vorgesehen, dass die Empfangsfrequenzen der an eine gemeinsame Antenne angeschlossenen Empfänger auf voneinander beabstandete Frequenzen eingestellt werden. Die angestrebte Flexibilisierung wird dabei erfindungsgemäß dadurch erreicht, dass die Vorfilter der Empfänger derart eingestellt werden, dass jede der eingestellten Empfangsfrequenzen jeweils im Durchlassbereich genau eines der Vorfilter liegt, wobei die Mittenfrequenzen der Durchlassbereiche der Vorfilter nicht mit den Empfangsfrequenzen übereinstimmen müssen.

Zur Steuerung der Vorfilter können dabei vorteilhafter Weise deren Mittenfrequenzen gesteuert, also die Lagen ihrer Durchlassbereiche über der Frequenzachse verschoben und/oder die Durchlassbandbreiten der Vorfilter gesteuert werden.

Von besonderem Vorteil ist es, wenn die Vorfilter nicht nur in Abhängigkeit der Empfangsfrequenzen beeinflusst werden, sondern wenn darüber hinaus der Einfluss der Vorfiltersteuerung auf zumindest eines der aus den empfangenen Funksignalen gewonnenen Nutzsignale zur Steuerung insbesondere der Vorfilter berücksichtigt wird. Dies kann in vorteilhafter Weise etwa dadurch realisiert werden, dass mindestens eines der Vorfilter zusätzlich in Abhängigkeit insbesondere von Qualitätssignalen gesteuert wird, die die Empfangsqualität mindestens eines mittels eines der Empfänger empfangenen Funksignals anzeigen.

Dazu kann in vorteilhafter Weise vorgesehen sein, dass mindestens eines der Vorfilter derart gesteuert wird, dass das aus dem mit dem zugehörigen Empfänger empfangenen Funksignal gewonnene Nutzsignal eine Mindestqualität aufweist. Darüber hinaus kann vorteilhaft vorgesehen sein, dass dann, wenn durch Steuerung des mindestens einen der Vorfilter eine Mindestqualität des aus dem mit dem zugehörigen Empfänger empfangenen Funksignal gewonnenen Nutzsignals nicht erreichbar ist, zusätzlich mindestens eine der Empfangfrequenzen derart gesteuert wird, dass der Abstand der Empfangsfrequenzen zueinander vergrößert wird. Damit wird ermöglicht, dass die Empfangsfrequenzen der Empfänger im Bereich der Mittenfrequenzen der Durchlassbereiche der Vorfilter und damit in Bereichen liegen, in denen die Dämpfung der Vorfilter für die jeweilige Empfangsfrequenz ein Minimum aufweist, so dass die Empfangsfrequenzen an den Empfängereingängen mit maximaler Signalstärke zur Verfügung stehen.

Zeichnungen

Ausführungsbeispiele der Erfindung sind in den Zeichnungen dargestellt und werden nachfolgend näher erläutert.
Es zeigen

Figur 1 zeigt ein Blockschaltbild eines Antennensignalsplitters gemäß dem beschriebenen Stand der Technik,

Figur 2 ein Blockschaltbild einer erfindungsgemäßen Anordnung zur Verwendung in einem mobilen Rundfunkempfänger, insbesondere einem Autoradio,

Figur 3 einen ersten Verlauf der Signalreflexionen infolge Fehlanpassung über der Rundfunkfrequenz,

Figur 4 einen zweiten Verlauf der Signalreflexionen infolge Fehlanpassung über der Rundfunkfrequenz zur Illustration vorliegender Erfindung,

Figur 5 weitere Verläufe der Signalreflexionen infolge Fehlanpassung über der Rundfunkfrequenz zur Illustration der Erfindung.

Beschreibung der Ausführungsbeispiele

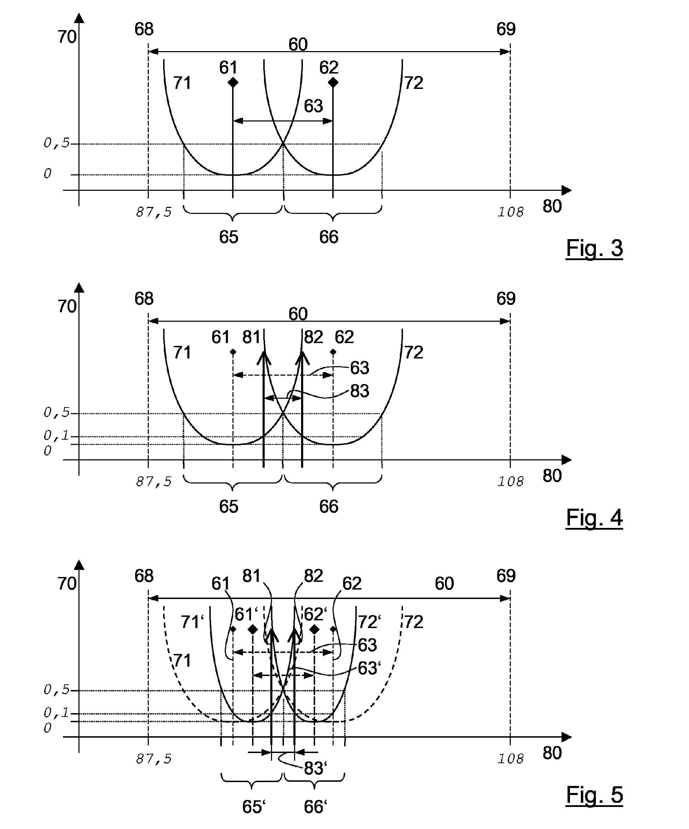

Die Erfindung eignet sich in besonderer Weise zum Einsatz in einem mobilen Rundfunkempfänger, beispielsweise einem Autoradiogerät, das zum Empfang von frequenzmodulierten Ultra-Kurz-Wellen- (UKW-) Rundfunksignalen ausgebildet ist. Die Erfindung wird daher nachfolgend am Beispiel eines Autoradios ohne Beschränkung der Allgemeinheit und ohne Ausschluss weiterer möglicher Anwendungsfälle, wie beispielsweise für anderweitige Funk- oder Rundfunkempfänger, Funkgeräte oder ähnliches beschrieben.
Das an einer Empfangsantenne 40 der erfindungsgemäßen Anordnung gemäß Figur 2 anstehende Rundfunkfrequenzgemisch, das aus einer Überlagerung der am Empfängerstandort empfangbaren Rundfunkfrequenzen besteht - in der Regel sind in dicht besiedelten Gebieten, wie in Europa, aufgrund der vorhandenen Senderlandschaft an nahezu jedem Empfängerstandort eine Mehrzahl von Rundfunkfrequenzen empfangbar - ist einem Eingang 14 eines Antennensignalsplitters 10 zugeführt. Dieser weist einen Transformator 12 mit einer Mehrzahl von Windungen auf. Das Antennensignal ist einer Mittelanzapfung 18 des Transformators 12 zugeführt. Ein zusätzlicher Eingangstransformator 11 ist zur Anpassung der Impedanz der Antenne 40 bzw. der Antennenzuleitung an die Eingangsimpedanz des splittenden, also des das Antennensignal aufteilenden, Transformators 12 vorgesehen. Von einem Abgriff 17 des Eingangstransformators 11, der einseitig mit der Antenne 40 und mit seinem entgegengesetzten Anschluss mit einem Bezugspotential 19 verbunden ist, wird das impedanzangepasste Antennensignal dem Mittelabgriff 18 des splittenden Transformators 12 zugeführt. Die jeweiligen Endanschlüsse des splittenden Transformators 12 bilden einen ersten Signalausgang 15 des Antennensignalsplitters 10 und mindestens einen zweiten Signalausgang 16 des Splitters 10. Der Splitter 10 umfasst weiterhin einen hochohmig ausgeführten ohmschen elektrischen Widerstand 13, der die Signalausgänge 15 und 16 des Antennensignalsplitters 10 miteinander verbindet. Erfindungsgemäß liegt der Wert des ohmschen Widerstands 13 mindestens um eine Größenordnung über der Antennenimpedanz bzw. der Ausgangsimpedanz der Signalausgänge 15 und 16 des Antennensignalsplitters 10. Gemäss einer Weiterbildung der Erfindung kann der Wert des ohmschen Widerstands 13 sogar soweit erhöht werden, dass dieser vollständig entfallen kann.

Beim in Figur 2 dargestellten Ausführungsbeispiel der Erfindung verfügt der Splitter 10 über zwei Signalausgänge 15 und 16. An den ersten Signalausgang 15 des Splitters 10 ist über eine erste Antennensignalzuleitung 25 das gesplittete Antennensignal einem ersten Empfänger 20 zugeführt.

Der erste Empfänger 20 umfasst ein erstes steuerbares Vorfilter 21, das eine schmalbandige Impedanzanpassung der Eingangsimpedanz 23 des ersten Empfängers 20 an die Leitungsimpedanz 24 der ersten Antennensignalzuleitung 25 ermöglicht. Der erste Empfänger 20 umfasst weiter ein erstes Empfangsteil 22, dem das durch den ersten Vorkreis 21 vorgefilterte Antennensignal zugeführt ist. Im ersten Empfangsteil 22 wird das Antennensignal durch Mischung mit einer geeignet gewählten ersten Mischfrequenz in eine Zwischenfrequenzebene, im Falle des betrachteten UKW-FM-Rundfunkempfängers beispielsweise bei 10,7 MHz - abweichende Zwischenfrequenzen, beispielsweise 24,9375 MHz, können je nach Anwendungsfall ebenfalls sinnvoll sein - herabgemischt. Die Mischfrequenz zur Herabmischung des eingehenden Antennensignals in die Zwischenfrequenzebene wird nach Maßgabe eines von einer Steuerung 50 zur Verfügung gestellten ersten Abstimmsteuersignals 522 bestimmt. Die Abstimmung des ersten Empfängers 20 auf eine bestimmte Empfangsfrequenz erfolgt somit durch entsprechende Wahl der Mischfrequenz nach Maßgabe eines entsprechenden ersten Abstimmsteuersignals 522.

Am Ausgang des ersten Empfangsteils 22 steht das zwischenfrequente Signal an einem Ausgang 26 zur hier im einzelnen nicht weiter interessierenden Weiterverarbeitung zur Verfügung. An einem weiteren Ausgang des ersten Empfangsteils 22 ist ein die Empfangsqualität des empfangenen Rundfunksignals bzw. der empfangenen Rundfunkfrequenz anzeigendes erstes Qualitätssignal 27 abnehmbar. Dieses kann beispielsweise die Empfangssignalfeldstärke der empfangenen Rundfunkfrequenz anzeigen. Darüber hinaus kann vorgesehen sein, dass mittels der Signalweiterverarbeitung 26 weitere, die Empfangsqualität der empfangenen Rundfunkfrequenz anzeigende Qualitätshilfssignale abgeleitet werden, die in das Qualitätssignal 27 einfließen können. Diese weiteren Qualitätshilfssignale sind in der Figur durch die Quelle 28 symbolisiert.

Die Steuerung 50 erzeugt neben dem ersten Abstimmsteuersignal 522 ein Vorfiltersteuersignal 521 zur Steuerung des ersten Vorfilters 21 dergestalt, dass eine ideale Impedanzanpassung der schmalbandigen Eingangsimpedanz 23 des ersten Vorfilters 21 an die Antennensignalzuleitungsimpedanz 24 jeweils im Bereich der mittels des Abstimmsteuersignals 522 eingestellten Empfangsfrequenz vorliegt.

An den zweiten Signalausgang 16 des Splitters 10 ist über eine zweite Antennensignalzuleitung 35 ein zweiter Empfänger 30 angeschlossen, der ein zweites steuerbares Vorfilter 31, das nach Maßgabe eines zweiten Vorfiltersteuersignals 531 gesteuert wird und ein zweites Empfangsteil 32, das nach Maßgabe eines zweiten Abstimmsteuersignals 532 von der Steuerung 50 gesteuert wird, umfasst. Das am Ausgang des zweiten Empfangsteils 33 abnehmbare Zwischenfrequenzsignal ist an einem zweiten Ausgang 36 abnehmbar und wird auch hier einer weiteren Verarbeitung zugeführt. Vergleichbar dem ersten Empfängerzug liefert auch das zweite Empfangsteil 32 ein die Empfangsqualität der empfangenen Rundfunkfrequenz anzeigendes zweites Qualitätssignal 37 an die Steuerung 50, das um Informationen aus der Weiterverarbeitung, hier repräsentiert durch die Quelle 38, ergänzt sein kann.

In Figur 3 sind die Verläufe 71, 72 der Impedanzanpassung der Vorfilter 21 und 31 in Abhängigkeit der jeweils eingestellten Empfangsfrequenz 61 bzw. 62 eines jeden Empfängers 20, 30 über der Empfangsfrequenz 80 dargestellt.

Die Bandbreiten 65 und 66 der Vorfilter 21 und 31, stellen die Abschnitte der in den Kurven 71 und 72 dargestellten Frequenzverläufe dar, innerhalb derer eine Impedanzanpassung der Vorfiltereingangsimpedanzen 23 und 33 und damit der Empfängereingangsimpedanzen erfolgt. Diese sind in der Figur durch die 3dB-Grenzfrequenzen gegeben.

Das Ziel vorliegender Erfindung ist, eine Antennensignalsplittung mit möglichst geringer Dämpfung für beide der mindestens zwei angeschlossenen Empfänger zu erreichen, kann die zur Charakterisierung von Filtern üblicherweise angewandte 3dB-Grenzfrequenz schon als mit einer zu starken Signaldämpfung einhergehend angesehen werden. Für diesen Fall empfiehlt sich die Defmition einer abweichenden Grenzfrequenz, z. B. einer 1dB-Grenzfrequenz und einer entsprechenden 1dB-Bandbreite, innerhalb derer eine Impedanzanpassung vorliegt.

Die 3dB-Bandbreiten der Kurven 71 und 72 gemäß Figur 3 ergeben sich beim vorliegenden Ausführungsbeispiel zu jeweils ungefähr 5 MHz. Wird eine 1dB-Bandbreite festgelegt, fällt diese entsprechend schmaler aus.

Bei einer Empfängeranordnung gemäß dem eingangs genannten Stand der Technik war nun folgende Vorgehensweise vorgesehen.

Wird beispielsweise am ersten Empfangsteil 22 mittels des ersten Abstimmsteuersignals 522 eine erste Empfangsfrequenz 61 eingestellt, wird das erste Vorfilter 21 mittels des ersten Vorfiltersteuersignals 521 derart nachgeführt, dass die Eingangsimpedanz 23 des ersten Vorfilters 21 respektive Empfängers 20 im Sinne einer Impedanzanpassung bestmöglich an die Impedanz 24 der ihm zugeführten Antennensignalzuleitung 25 angepasst wird. Dies bedeutet, dass die Kurve 71 in Figur 3 in Abhängigkeit einer am ersten Empfangsteil 22 eingestellten Empfangsfrequenz 61 dieser Empfangsfrequenz nachgeführt wird, so dass die Empfangsfrequenz 61 in der Darstellung stets in der Mitte der Kurve 71, also bei einem Dämpfungsminimum zu liegen kommt. Das bedeutet, dass für die jeweils eingestellte Empfangsfrequenz 61 zu jedem Zeitpunkt eine ideale Impedanzanpassung der Eingangsimpedanz 23 des Vorfilters 21 vorliegt, so dass für die eingestellte Empfangsfrequenz 61 ein Maximum an Antennensignalleistung aus dem Splitter 10 ausgekoppelt werden kann.

Wie Figur 3 zu entnehmen, erfolgt auch für den zweiten Empfänger 30 durch geeignete Steuerung des zweiten Vorfilters 31 in analoger Weise eine Impedanzanpassung der Eingangsimpedanz 33 des zweiten Vorfilters 31 an die Impedanz 34 der Antennensignalzuleitung 35 in Abhängigkeit der am zweiten Empfangsteil 32 eingestellten zweiten Empfangsfrequenz 62. Die Reflexion des am zweiten Signalausgang des Splitters 16 anstehenden Antennensignals am zweiten Vorfilter 31 ist in Figur 3 an Kurve 72 ablesbar, ebenso wie an der korrespondierende Kurve 71 für das am ersten Ausgang 15 des Antennensignalsplitters 10 anstehende Antennensignal.

Im Falle eines zum Betrieb im europäischen Raum vorgesehenen FM-UKW-Rundfunkempfängers liegt das interessierende Rundfunkfrequenzband 60 zwischen einer unteren Bandgrenze 68 von 87,5 MHz und einer oberen Bandgrenze 69 bei 108,0 MHz. Um die eingangs beschriebene Wirkung einer maximalen Signalauskopplung einer jeweils interessierenden Rundfunkfrequenz aus dem Antennensignalsplitter 10 zu ermöglichen, ist es erforderlich, dass für die beiden interessierenden Frequenzen 61 und 62 jeweils nur einer der beiden Empfänger 20 und 30 eine Eingangsimpedanzanpassung aufweist, während jeder der beiden Empfänger 20 und 30 für die jeweils andere der beiden Frequenzen 61 und 62 eine Eingangsimpedanzfehlanpassung aufweisen muss.

Dies kann gemäss vorliegender Erfindung dadurch erreicht werden, dass die mindestens zwei Empfänger 20, 30 der Vorrichtung 1 auf unterschiedliche Empfangsfrequenzen 61 und 62 abgestimmt werden, die einen Mindestfrequenzabstand 63 zueinander aufweisen, der sich aus der Bandbreite, innerhalb der die Vorstufen 21 und 31 eine Eingangsimpedanzanpassung aufweisen, ergibt. Die Bandbreite 65 und 66 des ersten und zweiten Vorfilters 21 und 31 ist bei dem in Figur 3 dargestellten Ausführungsbeispiel als jeweils der Frequenzbereich definiert, innerhalb dessen das Maß der Reflexion eines Antennensignals an der jeweiligen Vorstufe unter einem festgelegten Faktor, in dem Beispiel der Figur 1/2 (entspricht 3dB) liegt. Somit müssen erfindungsgemäß die beiden Empfangsfrequenzen 61 und 62, die an dem ersten Empfangsteil 22 und dem zweiten Empfangsteil 32 eingestellt sind, zueinander um den Mindestfrequenzabstand

$$\Delta f_{min} = {}^1/_2 \times (B_1 + B_2),$$

wobei

B_1: Bandbreite 65 des ersten Vorfilters 21,
B_2: Bandbreite 66 des zweiten Vorfilters 31,

im Fall der ersten Bandbreite 65 gleich der zweiten Bandbreite 66 um die Bandbreite 65 bzw. 66 der Vorfilter 21 bzw. 31, beabstandet sein. Die Bandbreite 65 bzw. 66 des ersten und des zweiten Vorfilters kann dabei, wie in der Figur dargestellt, durch die 3dB-Grenzfrequenzen, alternativ dazu aber auch vorzugsweise durch abweichende Grenzfrequenzen, bei denen eine geringere Signaldämpfung vorliegt, definiert sein.

Erfindungsgemäß wird von dieser beschriebenen Vorgehensweise wie im folgenden unter Bezugnahme auf die Figuren 4 und 5 dargestellt, abgewichen.

Ausführungsbeispiel 1:

Dieses Verfahren wird für solche Situationen vorgeschlagen, bei denen die Empfangsqualität eines ersten Empfängers 22 höhere Priorität genießt, als die eines zweiten Empfängers 32. Dies ist oftmals der Fall, wenn mit dem ersten Empfänger die Audiosignale eines Senders wiedergegeben werden sollen, wobei ein ungestörter Empfang angestrebt wird, und der zweite Empfänger für die Dekodierung von Datensignalen genutzt wird, die auf Grund einer geeigneten Codierung unempfmdlicher gegen Störeinflüsse sind, so dass hier eine Empfangsverschlechterung nicht zwangsläufig die Brauchbarkeit der Datensignale beeinträchtigen muss.

Wenn nun der Fall auftritt, dass die Empfangsfrequenzen der beiden Empfänger nahe beieinander liegen und sich die Empfänger durch gegenseitigen Energieentzug beeinträchtigen können, dann wird in regelmäßigen Abständen (z.B. interrupt-gesteuert) die Empfangsqualität im ersten Empfänger 22 ermittelt (Qualitätssignal 27, z.B. Feldstärkemessung, Auswertung von Stördetektoren 28 o.ä.). Solange die Empfangsqualität als so hoch eingestuft wird, dass eine Reduzierung durch den Energieentzug des zweiten Empfängers keine nennenswerte Verschlechterung bewirken kann, so wird der zweite Empfänger 32 wie gewünscht und mit Duldung des Energieentzugs auf der benachbarten Frequenz betrieben, d.h. der zweite Empfänger 32 ist mittels Signal 532 auf die gewünschte Empfangsfrequenz abgestimmt und auch das Vorfilter 31 ist mittels Signal 531 auf die gleiche Frequenz eingestellt. Wenn jedoch der Energieentzug zu einer nicht tragbaren Verschlechterung der Empfangsqualität im ersten Empfänger führen würde, so wird der zweite Empfänger zwar auf der gewünschten benachbarten Frequenz betrieben, das Vorfilter 31 dieses zweiten Empfängers wird jedoch nicht auf die Empfangsfrequenz abgestimmt, sondern mittels Signal 531 auf eine Frequenz, die einerseits zur Empfangsfrequenz des ersten Empfängers einen vorgesehenen Mindestabstand aufweist, der eine nennenswerte Beeinträchtigung der Empfangsqualität des ersten Empfängers verhindert, und andererseits möglichst nahe an der Empfangsfrequenz des zweiten Empfängers liegt, um auch dessen Empfangsqualität nur im für den Betrieb des ersten Empfängers notwendigen Umfang zu beeinträchtigen.

Ausführungsbeispiel 2 (Figur 4):

Die Verstimmung des Vorfilters muss nicht auf einen Empfänger beschränkt bleiben. Wenn auch die Empfangsqualität des zweiten Empfängers nicht zufriedenstellend ist, so kann neben den Maßnahmen aus Beispiel 1 auch das Vorfilter 21 des ersten Empfängers 22 mittels Signal 521 neben die eigentliche Empfangsfrequenz abgestimmt werden. Somit wird unter Duldung einer geringfügigen Empfangsverschlechterung im ersten Empfänger eine Kompromisseinstellung gewählt, die auch die Beeinträchtigung des zweiten Empfängers 32 in der zuvor beschriebenen Wirkungsweise reduziert.

Ausführungsbeispiel 3:

Gegenüber Beispiel 1 wird im Fall einer nicht tragbaren Verschlechterung der Empfangsqualität des ersten Empfängers nicht die Frequenz des Vorfilters des zweiten Empfängers verstellt, sondern die Güte dieses Filters erhöht, so dass durch die schmalere Filterdurchlasskurve dieses Kreises die Beeinträchtigung des ersten Empfängers verringert wird. Die Anhebung der Güte kann durch eine geringere Ankopplung zwischen dem Vorfilter des zweiten Empfängers und den diesem Filter vor- bzw. nachgeschalteten Stufen erfolgen, was aber eine geringere Signalstärke und somit Empfangsqualität im zweiten Empfänger zur Folge hat.

Im Falle der Figur 5 kommen beide vorgeschlagenen Strategien gemeinsam zur Anwendung kommen, nämlich die bewusste Verstimmung der Vorfilter und die Erhöhung der Güte in diesen Filtern. Die bisherige Beispielbeschreibung geht davon aus, dass nur in einem Empfänger die Filtergüte verstellt wird, vorzugsweise über die Stärke der Filterankopplung. Auch hier ist davon abweichend eine Steuerung mehrerer Filter denkbar.

**Patentansprüche**

1. Empfängeranordnung mit mindestens zwei an eine gemeinsame Antenne (40) angeschlossenen Empfängern (20, 30), die über Antennensignalleitungen (25, 35) mit der Antenne (40) verbunden sind,
wobei jeder der Empfänger (20, 30) ein steuerbares Vorfilter (21, 31) mit bandpassförmiger Charakteristik und eine steuerbare Empfangsfrequenz (81, 82) aufweist,
mit einer Steuerung (50) zur Steuerung der Vorfilter (23, 33) und der Empfangsfrequenzen (81, 82) der Empfänger,
wobei die Steuerung (50) dazu ausgebildet ist, die Empfangsfrequenzen der Empfänger (20, 30) voneinander unabhängig auf voneinander verschiedene Funkfrequenzen (81, 82) einzustellen **dadurch gekennzeichnet,**
**dass** die Steuerung (50) ferner dazu ausgebildet ist, die Vorfilter (21, 31) derart einzustellen, dass jede der eingestellten Empfangsfrequenzen (81, 82) im Durchlassbereich des jeweiligen Vorfilters (21, 31) liegt, wobei die Mittenfrequenzen (61, 62) der Durchlassbereiche der Vorfilter (21,31) nicht mit den Empfangsfrequenzen (81, 82) übereinstimmen müssen.

2. Empfängeranordnung nach Anspruch 1, **dadurch gekennzeichnet, dass** die Steuerung (50) dazu ausgebildet ist, die Mittenfrequenzen (61, 62) der Vorfilter (21, 31) zu steuern.

3. Empfängeranordnung nach Anspruch 1 oder 2, **dadurch gekennzeichnet, dass** die Steuerung (50) dazu ausgebildet ist, die Durchlassbandbreite (65, 66) mindestens eines der Vorfilter (21, 31) zu steuern.

4. Empfängeranordnung nach einem der vorhergehenden Ansprüche, **dadurch gekennzeichnet, dass** die Steuerung (50) dazu ausgebildet ist, mindestens eines der Vorfilter (21,31) zusätzlich in Abhängigkeit weiterer Einflussgrößen, insbesondere in Abhängigkeit von Qualitätssignalen zu steuern, die die Empfangsqualität mindestens eines mittels eines der Empfänger (20, 30) empfangenen Funksignals anzeigen.

5. Verfahren zur Steuerung von an eine gemeinsame Antenne (40) angeschlossenen Empfängern (20, 30), von denen jeder ein steuerbares Vorfilter (21, 31) mit Bandpasscharakteristik aufweist, wobei die Empfangsfrequenzen der Funkempfänger auf voneinander verschiedene Funkfrequenzen (81, 82) eingestellt werden, **dadurch gekennzeichnet, dass** die Vorfilter (21, 31) derart eingestellt werden, dass jede der eingestellten Empfangsfrequenzen (81, 82) im Durchlassbereich des jeweiligen Vorfilters (21, 31) liegt, wobei die Mittenfrequenzen (61, 62) der Durchlassbereiche der Vorfilter (21,31) nicht mit den Empfangsfrequenzen (81, 82) übereinstimmen müssen.

6. Verfahren nach Anspruch 5, **dadurch gekennzeichnet, dass** die Mittenfrequenzen (61, 62) der Vorfilter (21,31) gesteuert werden.

7. Verfahren nach Anspruch 5 oder 6, **dadurch gekennzeichnet, dass** die Durchlassbandbreite mindestens eines der Vorfilter (21, 31) gesteuert wird.

8. Verfahren nach einem der Ansprüche 5 bis 7, **dadurch gekennzeichnet, dass** mindestens eines der Vorfilter (21, 31) zusätzlich in Abhängigkeit weiterer Einflussgrößen, insbesondere in Abhängigkeit von Qualitätssignalen gesteuert wird, die die Empfangsqualität mindestens eines mittels eines der Empfänger (20, 30) empfangenen Funksignals anzeigen.

9. Verfahren nach Anspruch 8, **dadurch gekennzeichnet, dass** in Abhängigkeit davon, ob das aus mindestens einem Empfänger (20, 30) empfangenen Funksignal gewonnene Nutzsignal eine Mindestqualität aufweist, die Mittenfrequenz und/oder die Durchlassbandbreite mindestens eines der Vorfilter (21, 31) gesteuert wird.

Fig. 1

Fig. 2

Fig. 3

Fig. 4

Fig. 5

**Europäisches**
**Patentamt**

**EUROPÄISCHER RECHERCHENBERICHT**

Nummer der Anmeldung

EP 04 10 4849

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | WO 03/005488 A (BOSCH GMBH ROBERT ; PITZ GERHARD (DE); POCHOWSKI LUTZ (DE); KOTTSCHLAG) 16. Januar 2003 (2003-01-16) * das ganze Dokument * ----- | 1,5 | H01P1/213 H03H7/46 |
| A | EP 1 357 670 A (BOSCH GMBH ROBERT) 29. Oktober 2003 (2003-10-29) * das ganze Dokument * ----- | 1,5 | |

**RECHERCHIERTE SACHGEBIETE (Int.Cl.7)**

H03H
H01P

Der vorliegende Recherchenbericht wurde für alle Patentansprüche erstellt

| Recherchenort | Abschlußdatum der Recherche | Prüfer |
|---|---|---|
| Den Haag | 5. Januar 2005 | Den Otter, A |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 10 4849

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-01-2005

| Im Recherchenbericht angeführtes Patentdokument | Datum der Veröffentlichung | Mitglied(er) der Patentfamilie | Datum der Veröffentlichung |
|---|---|---|---|
| WO 03005488 A | 16-01-2003 | DE 10131457 A1<br>WO 03005488 A1<br>EP 1405370 A1<br>US 2004239443 A1 | 09-01-2003<br>16-01-2003<br>07-04-2004<br>02-12-2004 |
| EP 1357670 A | 29-10-2003 | DE 10218697 A1<br>EP 1357670 A2 | 06-11-2003<br>29-10-2003 |

EPO FORM P0461

Für nähere Einzelheiten zu diesem Anhang : siehe Amtsblatt des Europäischen Patentamts, Nr.12/82